# EUROPEAN PATENT SPECIFICATION

(11) **EP 2 068 389 B1**
(45) Date of publication and mention of the grant of the patent: **21.06.2017**
(21) Application number: 07807841.7
(22) Date of filing: 25.09.2007
(51) Int. Cl.: C23C 14/58, C23C 14/16, C23C 14/34, H01M 8/0208, H01M 8/0228, H01M 8/0206, H01M 8/1018

(54) **METHOD FOR PRODUCING SEPARATOR FOR FUEL CELL, SEPARATOR FOR FUEL CELL, AND FUEL CELL**
VERFAHREN ZUM HERSTELLEN EINES TRENNGLIEDS FÜR EINE BRENNSTOFFZELLE, TRENNGLIED FÜR EINE BRENNSTOFFZELLE UND BRENNSTOFFZELLE
PROCÉDÉ DE PRODUCTION D'UN SÉPARATEUR POUR PILE À COMBUSTIBLE, SÉPARATEUR POUR PILE À COMBUSTIBLE ET PILE A COMBUSTIBLE

(30) Priority: 29.09.2006 JP 2006268352; 02.02.2007 JP 2007024418; 01.08.2007 JP 2007201240
(43) Date of publication of application: 10.06.2009
(73) Proprietor: Kabushiki Kaisha Kobe Seiko Sho, Chuo-ku Kobe-shi Hyogo 651-8585 (JP)
(72) Inventor: SATO, Toshiki, Hyogo 651-2271 (JP); SUZUKI, Jun, Hyogo 651-2271 (JP); YASHIKI, Takashi, Hyogo 651-2114 (JP)
(74) Representative: Müller-Boré & Partner Patentanwälte PartG mbB
(86) International application number: PCT/JP2007/068570
(87) International publication number: WO 2008/041560

(56) References cited:
- EP-A1- 1 235 288
- EP-A2- 1 237 215
- DE-A1- 10 356 653
- JP-A- 2001 297 777
- JP-A- 2002 367 434
- JP-A- 2003 203 644
- JP-A- 2004 134 276
- JP-A- 2006 278 172
- US-A- 4 181 590

## Description

The present invention relates to a fuel cell separator and a fuel cell made of Ti or a Ti alloy for solid polymer fuel cells used for portable devices such as cellular phones and personal computers, household fuel cells, fuel cell automobiles.

In recent years, fuel cells are expected to become an energy source which solves global environment problems and energy problems.

In particular, since solid polymer fuel cells can operate at low temperatures and can achieve reduction in size and weight, their application as power supplies for household co-generation systems and portable devices, and for fuel cell automobiles is contemplated.

Herein, a typical solid polymer fuel cell is so constituted as to have: catalyst layers, which serve as an anode and a cathode, being on both sides of a solid polymer membrane which is an electrolyte; gas diffusion layers being outside the catalyst layers; and a separator where fuel gas channels are formed outside the gas diffusion layers.

Since this separator serves not only as a channel of the gas, but also as a component for drawing a current, it is required to have a high conductivity. Separators made of carbon, which have been heretofore used, are far from being desirable from a perspective of achieving reduction in size and weight, since their thickness needs to be large in terms of strength.

It has been studied to form separators from a metal which can be formed in a thin thickness in order to achieve reduction in size and weight. However, the inside of a fuel cell (solid polymer fuel cell) is in an acidic atmosphere, which is considered a corrosive circumstance for a metal. Accordingly, separators of a metal used for fuel cells need to have good corrosion resistance and conductivity.

Metals such as stainless steel and Ti are imparted good corrosion resistance by forming passivation films on their surfaces. This passivation film increases contact resistance to the gas diffusion layer. It is therefore known that this increased contact resistance deteriorates the power generation efficiency of a fuel cell by suppressing conductivity.

Meanwhile, metals which form no passivation film such as iron have good conductivity, but easily corrode and leach out. The leaching ions deteriorate catalyst characteristics and lower the ionic conductivity of the solid polymer membrane. It is therefore known that the power generating characteristics of the fuel cell is deteriorated consequently.

Therefore, the following separators are suggested: a separator made of a metal whose surface is plated with gold (for example, refer to Patent document 1); a separator coated with a precious metal or an alloy of precious metals on the surface of a separator made of stainless steel or Ti by ion deposition or plating (for example, refer to Patent document 2) ; and a separator of an anti-corrosion metal material on the surface of which a precious metal layer is formed (for example, refer to Patent document 3).

These inventions attempt to maintain high corrosion resistance and low contact resistance by forming a metal surface of a precious metal having high corrosion resistance without forming a passivation film on the surface thereof.
[Patent document 1] Japanese Unexamined Patent Application Publication No.H10-228914
[Patent document 2] Japanese Unexamined Patent Application Publication No. 2001-6713
[Patent document 3] Japanese Unexamined Patent Application Publication No. 2004-158437

Further, JP 2004-134276 A discloses a method for producing a metal separator for solid polymer fuel cells, wherein a precious metal layer is formed on the surface of a substrate made of Ti or a Ti alloy by means of PVD and a diffusion layer is formed therebetween by a heat treatment step. EP 1 235 288 A1 discloses a polymer electrolyte fuel cell comprising a polymer electrolyte membrane; an anode and a cathode sandwiching said polymer electrolyte membrane therebetween; an anode-side conductive separator plate having a gas channel for supplying a fuel gas to said anode; and a cathode-side conductive separator plate having a gas channel for supplying an oxidant gas to said cathode, wherein each of said anode-side and cathode-side conductive separator plates comprises a metal plate, an oxidation-resistant conductive film covering partially or entirely a surface of said metal plate facing said anode or cathode, and a diffused layer resulting from diffusion of a material of said conductive film at an interface between said metal plate and conductive film.

However, in the invention described in Japanese Unexamined Patent Application Publication No.H10-228914, it is not only that the adhesion of the metal is lowered if the passivation film on the surface is not removed, but also that the contact resistance is increased by this passivation film (that is, conductivity is lowered). Accordingly, the passivation film is removed by carrying out a surface activation step. However, a passivation film is formed in a cleaning step carried out prior to a plating step, and therefore there are disadvantages that sufficient adhesion cannot be obtained and that contact resistance cannot be lowered.

Moreover, in the invention described in Japanese Unexamined Patent Application Publication No. 2001-6713, in which Pt, which is a precious metal, is deposited by a corrosion reaction, while mechanically grinding the surface made of stainless steel or Ti. When such a process is carried out, the contact resistance is lowered since Pt is deposited in a part where the passivation film has been removed (that is, conductivity is increased), but a compact precious metal layer is not formed because of formation of pinholes (portions where the substrate is partially exposed out of the surface) or there are other problems. Therefore, there are the disadvantages that stainless steel or Ti leaches out from the pinholes by its use in an acidic atmosphere such as in fuel cells and that the power generating characteristics of the fuel cells are deteriorated. Moreover, the method of blasting the separator with glass beads which are plated with a precious metal is also suggested, but it has the disadvantage that deformation which can be caused by blasting lowers the usability of the separator since it is required to have high dimensional accuracy.

The invention described in Japanese Unexamined Patent Application Publication No. 2004-158437 also has a precious metal layer formed by plating, and therefore it is thought that the precious metal layer is formed on a passivation film. Accordingly, it has the disadvantages that sufficient adhesion cannot be obtained and that contact resistance cannot be lowered.

An object of the present invention is to provide a fuel cell separator made of Ti or a Ti alloy having excellent corrosion resistance, good adhesion of a precious metal layer, low contact resistance, and further excellent productivity,and a fuel cell using the fuel cell separator.
[1] A fuel cell separator wherein a precious metal layer including at least one precious metal selected from Ru, Rh, Pd, Os, Ir, Pt and Au and having a thickness of 2 nm or more is formed on the surface of a substrate made of Ti or a Ti alloy, and wherein titanium oxide layer including at least one of rutile type crystals and brookite type crystals is formed between the precious metal layer and the substrate and in a portion where the substrate is exposed out of the surface.
[2] The fuel cell separator according to [1], wherein the substrate has a recess for forming a gas channel for circulating a gas formed in at least a part of the surface thereof, and the precious metal layer is formed on the surface of the substrate on which the recess was formed.
[3] A fuel cell including a fuel cell separator according to [1] or [2].

The fuel cell separator according to the present invention is characterized in that a precious metal layer including at least one precious metal selected from Ru, Rh, Pd, Os, Ir, Pt and Au and having a thickness of 2 nm or more is formed on the surface of the substrate made of Ti or a Ti alloy, and a titanium oxide layer containing at least one of rutile type crystals and brookite type crystals is formed between the precious metal layer and the substrate and in a portion where the substrate is exposed out of the surface. Moreover, the fuel cell separator according to the present invention may include a recess for forming a gas channel for circulating a gas formed in at least a part of the surface of the substrate, and the precious metal layer may be also formed on the surface of the substrate on which the recess is formed.

Since the fuel cell separator according to the present invention has a titanium oxide layer containing at least one of rutile type crystals and brookite type crystals formed between the precious metal layer and the substrate and in a portion where the substrate is exposed out of the surface, its contact resistance can be further lowered. That is, its conductivity can be improved.

The fuel cell according to the present invention uses the above-mentioned fuel cell separator. Since the fuel cell of the present invention uses the above-mentioned fuel cell separator, it has excellent corrosion resistance, good adhesion of the precious metal layer, low contact resistance, and further excellent productivity.

Moreover, the fuel cell separator according to the present invention has excellent corrosion resistance, good adhesion of the precious metal layer, low contact resistance, and further excellent productivity.

In addition, the fuel cell according to the present invention has excellent corrosion resistance, good adhesion of the precious metal layer, low contact resistance, and further excellent productivity.
[Fig. 1] Fig. 1 is a flowchart which illustrates the steps of the method for manufacturing a fuel cell separator according to the present invention.
[Fig. 2] Fig. 2 (a) is a cross-sectional view of a fuel cell separator and 2 (b) is a cross-sectional view of the fuel cell separator according to the present invention.
[Fig. 3] Fig. 3 is an explanatory drawing for illustrating a method for measuring contact resistance.
[Fig. 4] Fig. 4 is a drawing which shows an example of the shape of the gas channel formed on the surface of the substrate.
[Fig. 5] Fig. 5 is a development of a part of a fuel cell which uses the fuel cell separator of the present invention.
[Fig. 6] Fig. 6 is a graphical representation which shows the relationship between the heat treatment time (t) and heat treatment temperature (T).

### Description of the Numerals

- S1: Recess formation step
- S2: Step for forming precious metal layer
- S3: Heat treatment step
- 1: Fuel cell separator
- 2: Substrate
- 3: Precious metal layer
- 4: Diffusion layer
- 10: Single cell
- 11: Gas channel
- 12: Gas diffusion layer
- 13: Solid polymer membrane
- 20: Fuel cell

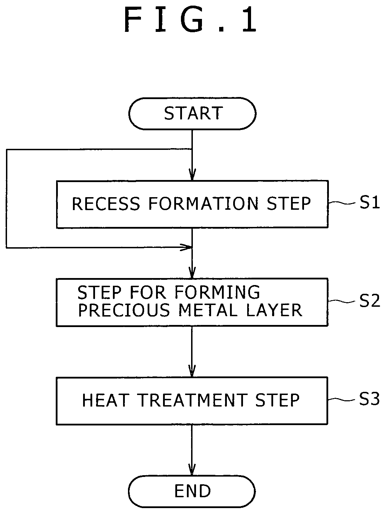

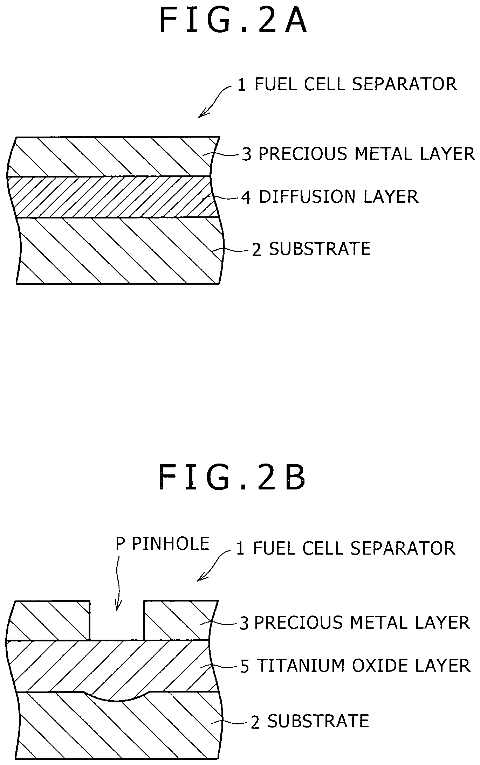

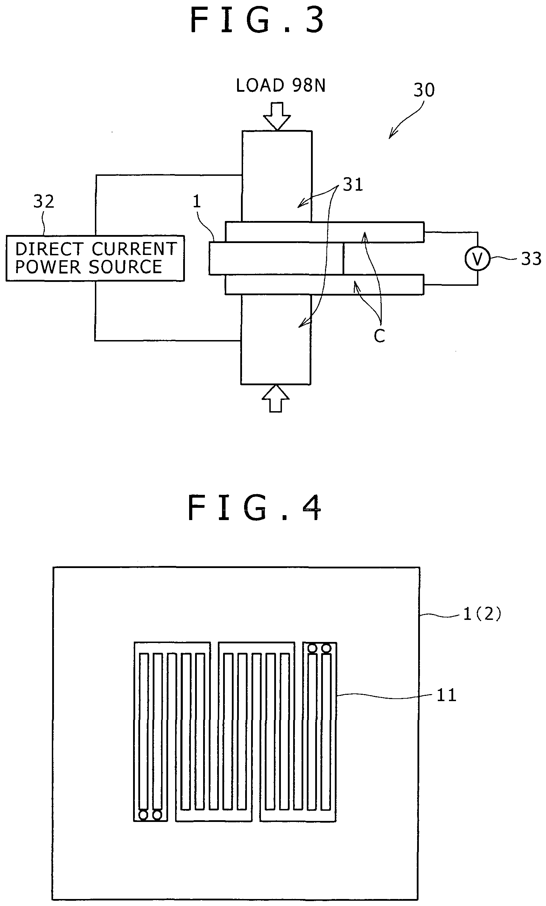

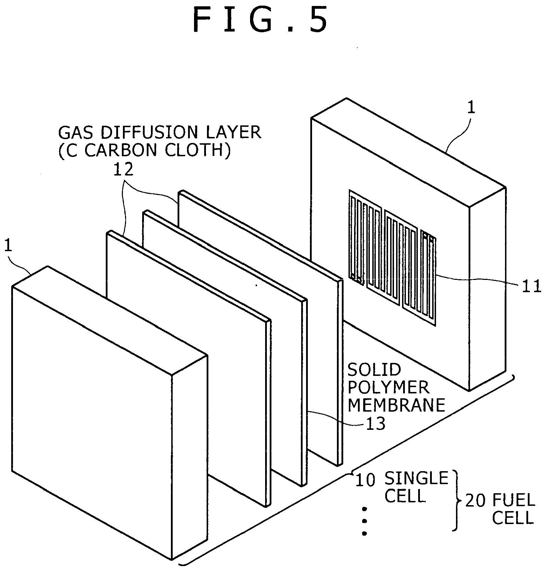

The best mode for carrying out the fuel cell separator and a fuel cell according to the present invention will be now described with reference to drawings as appropriate. In the referred drawings, Fig. 1 is a flowchart which illustrates the steps of the method for manufacturing a fuel cell separator according to the present invention. Fig. 2(b) is a cross-sectional view of the separator of the fuel cell according to the present invention. Fig. 3 is an explanatory drawing for illustrating a method for measuring contact resistance. Fig. 4 is a drawing which shows an example of the shape of the gas channel formed on the surface of the substrate. Fig. 5 is a development of a part of a fuel cell which uses the fuel cell separator of the present invention.

It should be noted that in the referred drawings, numeral S1 represents the recess formation step; numeral S2 represents the precious metal layer forming step; numeral S3 represents the heat treatment step; numeral 1 represents the fuel cell separator; numeral 2 represents the substrate; numeral 3 represents the precious metal layer; numeral 4 represents the diffusion layer; numeral 10 represents the single cell; numeral 11 represents the gas channel; numeral 12 represents the gas diffusion layer; numeral 13 represents the solid polymer membrane; and numeral 20 represents the fuel cell.

First, the method for manufacturing a fuel cell separator of the present invention will be described.

As shown in Fig. 1, the method for manufacturing the fuel cell separator 1 of the present invention includes the precious metal layer forming step S2 and the heat treatment step S3. Moreover, the method for manufacturing a fuel cell separator of the present invention may include the recess formation step S1 prior to the precious metal layer forming step S2.

In the recess formation step S1, a recess for forming the gas channel 11 (refer to Figs. 4 and 5) for circulating a gas such as hydrogen gas and air is formed in at least a part of the surface of the substrate 2 as a fuel cell separator made of Ti or a Ti alloy. Herein, the surface of the substrate 2 means the face which constitutes the outside of the substrate 2, and includes the so-called surface, back side, and side faces.

Herein, an apparatus for forming the gas channel in at least a part of the surface of the substrate 2 is not particularly limited, and a known apparatus which can achieve the desired object can be suitably used.

It is preferable that prior to this formation step S1, the longitudinal width, lateral width, thickness and other parts of the substrate 2 are formed to have predetermined dimensions and shapes.

In the precious metal layer forming step S2, the precious metal layer 3 including at least one precious metal selected from Ru, Rh, Pd, Os, Ir, Pt and Au and having a thickness of 2 nm or more is formed on the surface of the substrate 2 made of Ti or a Ti alloy (the entire surface of the substrate 2 or a part of the surface) by a PVD (Physical Vapor Deposition) method. Examples of PVD methods which can be used in the present invention include sputtering, vacuum vapor deposition, ion plating, among others. Among these, sputtering is suitable since it can easily control the thickness of the precious metal layer 3. Moreover, in the precious metal layer forming step S2, the precious metal layer 3 may be formed on the surface of the substrate made of Ti or a Ti alloy on which the recess is formed.

Examples of the substrate 2 include type 1 to 4 pure Ti substrates defined in JIS H 4600 1, and substrates made of Ti alloys such as Ti-Al, Ti-Ta, Ti-6Al-4V, Ti-Pd. However, the substrate 2 which can be used in the present invention is not limited to these examples, and Ti alloys which contain other metal elements and other substances can be also used suitably.

Precious metals (Noble metal) such as Ru, Rh, Pd, Os, Ir, Pt and Au are known to have excellent corrosion resistance, excellent conductivity since they are transition metals, and, similar characteristics although they do not form passivation films. Therefore, good corrosion resistance and conductivity can be imparted by forming the precious metal layer 3 including a precious metal selected appropriately from these.

The thickness of the precious metal layer 3 formed in this step for forming precious metal layer S2 needs to be 2 nm or more. When the thickness of the precious metal layer 3 is less than 2 nm, an excessive number of pinholes are formed, oxidation of Ti and Ti alloy when the heat treatment described later is conducted reaches as far as the lower side of the precious metal layer 3. Therefore, contact resistance cannot be lowered. The thickness of the precious metal layer 3 formed in the precious metal layer forming step S2 is more preferably 3 nm or more, and the most preferably 5 nm or more.

Although the upper limit value of the thickness of the precious metal layer 3 is not particularly limited, it is preferable that the thickness is 500 nm or less from a perspective of reducing the time and cost required for forming the precious metal layer 3.

In the precious metal layer forming step S2, the precious metal layer 3 of the above-mentioned precious metal is formed by a PVD method. A PVD method can form the precious metal layer 3 on the substrate 2 even at room temperature, and therefore it can not only reduce the damage (for example, warping, lowered strength, etc.) caused on the substrate 2, but also allows the precious metal layer 3 to be formed over a relatively large area, thereby increasing productivity.

In this step for forming precious metal layer S2, the precious metal layer 3 may be formed by heating the substrate 2 to 300 to 800°C. Since the step allows quick transition to the heat treatment step S3 described later, the manufacture of the fuel cell separator 1 is facilitated.

In carrying out this step for forming precious metal layer, it is also possible to clean the substrate 2 in advance by ultrasound wave cleaning or other cleaning methods using an organic solvent such as acetone. Performing such cleaning is desirable since formation of pinholes and adhesion failure resulting from soil on the surface of the substrate 2 can be reduced.

In the heat treatment step S3, the substrate 2 on which the precious metal layer 3 is formed in the precious metal layer forming step S2 is subjected to a heat treatment at a predetermined heat treatment temperature and under a predetermined oxygen partial pressure to form the precious metal layer 3, and the crystallized passivation film (titanium oxide layer 5 (refer to Fig. 2(b))) having high conductivity is formed between the precious metal layer 3 and the substrate 2, thereby producing the fuel cell separator 1.

That is, this heat treatment step S3 can form the partially or entirely crystallized passivation film (titanium oxide) by carrying out the heat treatment under predetermined conditions.

Herein, the passivation film formed on the surface of the substrate 2 prior to the heat treatment is partially or entirely crystallized by the heat treatment. In this crystallization, since the passivation film which is directly under the precious metal layer 3 is shut off from oxygen supply by the precious metal layer 3, oxygen is diffused in the Ti base material and diluted, and the passivation film is converted into oxygen-deficient titanium oxide (titanium oxide having a graded oxygen-deficient structure). This crystallized titanium oxide turns into an n-type semiconductor with increased conductivity when oxygen is deficient to such a degree that it is lower than the stoichiometric ratio. That is, the conductivity of the passivation film formed on the surface of the substrate 2 can be improved by the heat treatment. Examples of the crystal structure of such titanium oxide include rutile type crystals or brookite type crystals. It should be noted that the rutile type crystal means a crystal which has the same crystal structure as rutile crystals, and the brookite type crystal means a crystal which has the same crystal structure as brookite crystals. It should be noted that the lower the oxygen partial pressure in the heat treatment, the more likely the oxide film 4 having such deficient type rutile type crystals and brookite type crystals are obtained. It is also more easily obtained by carrying out the heat treatment under conditions with less oxygen, such as in the portion covered by the precious metal layer 3.

By further continuing the heat treatment or increasing the heat treatment temperature, the passivation film before being subjected to the heat treatment and the layer of titanium oxide having high conductivity formed in the manner described above disappear, and a diffusion layer 4 in which the element of the precious metal and Ti are diffused into each other is formed between the precious metal layer 3 and the substrate 2.

It is thought that by carrying out such a treatment even when the passivation film remains, soil such as hydrocarbon which was present on the passivation film is decomposed by heat and diffused into in the precious metal layer 3 so that the surface becomes clean and the precious metal layer 3 is brought into contact with the surface of the clean passivation film and/or the crystallized passivation film (that is, oxygen-deficient titanium oxide), whereby the coherence between the crystallized passivation film and the crystal lattice of the precious metal and the adhesion are improved.

It should be noted that when a heat treatment at a high temperature or for long term is carried out, the passivation film completely disappears, and the diffusion layer 4 in which the element of the precious metal layer 3 and Ti of the substrate 2 are diffused is formed between the precious metal layer 3 and the substrate 2.

Therefore, according to the method for manufacturing a fuel cell separator of the present invention, simply by carrying out the heat treatment step S3 after the step S2 for forming precious metal layer by a PVD method without carrying out any complicated step, when the passivation film is remaining, the passivation film can be partially or entirely converted into an oxygen-deficient and conductive crystallized passivation film (titanium oxide layer 5).

The heat treatment temperature in the heat treatment step S3 is preferably 300 to 800°C. This is for allowing crystallization of the passivation film to increase the adhesion of the precious metal layer 3 and lower the contact resistance, removal of the passivation film, and oxidation of Ti which is exposed at pinholes to ensure the corrosion resistance of the separator.

When the heat treatment temperature is lower than 300°C, it is not practical because crystallization of the passivation film and removal of the passivation film take too much time.

Moreover, when the heat treatment temperature is higher than 800°C, the precious metal element and Ti of the substrate 2 are diffused into each other excessively because diffusion is too fast. Accordingly, titanium diffuses into the outermost surface of the precious metal layer 3 and is bonded to oxygen in the heat treatment atmosphere, which may form a titanium oxide layer (oxide film) containing rutile type crystals and brookite type crystals. However, since such an oxide film is formed by being in contact with the atmosphere containing oxygen, the resulting oxide film has an insufficient level of deficiency of oxygen, and its contact resistance becomes undesirably high although its corrosion resistance is higher than that of the passivation film (titanium oxide layer 5) . The heat treatment temperature is more preferably 350 to 750°C, and most preferably 380 to 730°C. Moreover, even when the heating temperature is in such a temperature range, conducting a long-term heat treatment may cause titanium to be diffused into the surface and form an oxide film, and therefore it is preferable to suitably adjust the heat treatment time with respect to the heat treatment temperature.

In the heat treatment time in the heat treatment step S3, in order to lower contact resistance (that is, improve conductivity) by crystallizing the passivation film which exists between the precious metal layer 3 and the substrate 2, and to remove the passivation film or reduce the thickness of the same to a sufficient degree, it is preferable that when the heat treatment time is t (minutes), and the heat treatment temperature is T (°C), while 300≤T≤800, (420-T)/40≤t≤EXP [(806.4-T)/109.2] and t≥0.5.

That is, it is preferable that while 300≤T≤400, (420-T)/40≤t≤EXP [(806.4-T)/109.2], and while 400≤T≤800, 0.5≤t≤EXP[(806.4-T)/109.2].

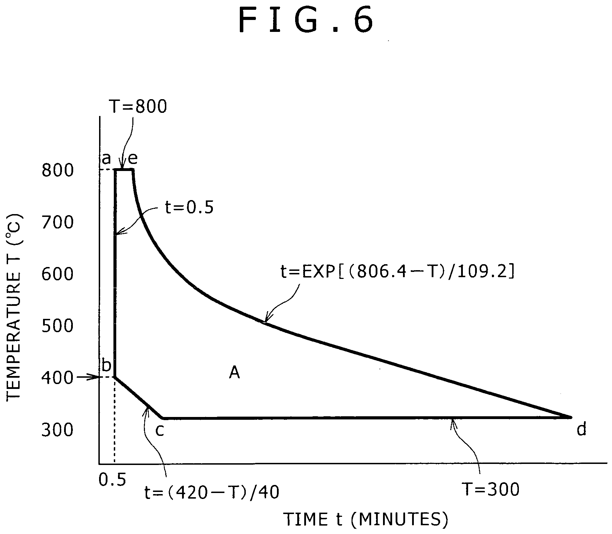

Fig. 6 is a graphical representation which shows the relationship between the heat treatment time (t) and heat treatment temperature (T) . In addition, as shown in Fig. 6, it is preferable in the present invention to carry out the heat treatment under the heat treatment conditions (heat treatment time (t) and heat treatment temperature (T)) of a region A defined by straight line ab (t=0.5), straight line bc (t=(420-T)/40), straight line cd (T=300), curve de (t=EXP[(806.4-T)/109.2]) and straight line ea (T=800).

When the heat treatment time (t) is shorter than (420-T)/40 minutes (heat treatment temperature is lower than 300≤T≤400 (°C)) or 0.5 minutes (heat treatment temperature is 400≤T≤800 (°C)), crystallization of the passivation film (improvement in conductivity) and removal of the passivation film may not be sufficiently achieved. Accordingly, it is not only that the adhesion of the precious metal layer 3 cannot be increased, but also that contact resistance cannot be lowered.

Meanwhile, when the heat treatment time is longer than [EXP (806.4-T)/109.2] minutes (heat treatment temperature is 300≤T≤800 (°C)), although depending on the thickness of the precious metal layer 3, the precious metal element and Ti of the substrate 2 may be excessively diffused into each other, and an oxide film is likely to be formed on the outermost surface. As mentioned above, when an oxide film is formed, contact resistance tends to be increased. Moreover, although depending on the heat treatment temperature, the precious metal element and Ti of the substrate 2 may be excessively diffused into each other in some cases.

It is preferable that the oxygen partial pressure in the heat treatment step S3 is suitably set depending on the type of the precious metal used. Among the precious metals mentioned earlier, Pd, Ru, Rh, Os and Ir are oxidized when the oxygen partial pressure is high and their contact resistance is increased.

It should be noted that in the present invention the phrase "oxygen partial pressure" means the pressure produced by oxygen (in the present invention, it is assumed that the composition of air is nitrogen: oxygen = about 4:1.) in the heat treatment furnace in which the heat treatment step S3 is carried out.

More specifically, when the precious metal is at least one member selected from Ru, Rh, Pd, Os, and Ir, it is preferable that the oxygen partial pressure is 1.33 Pa 1×10⁻² Torr) or lower.

When the oxygen partial pressure in the heat treatment step S3 is higher than 1.33 Pa (1×10⁻² Torr), the amount of oxygen in the atmosphere in which the heat treatment is conducted is too high. Therefore, it is likely that these precious metals are oxidized and their contact resistance is increased. The lower the oxygen partial pressure, the more desirable. The pressure is more preferably 0.665 Pa (5×10⁻³ Torr or lower), and still more preferably 0.133 Pa (1×10⁻³ Torr or lower).

It should be noted that even under a condition of low oxygen partial pressure, Ti exposed at pinholes and other portions is oxidized as long as oxygen is present in the atmosphere. However, since oxidation of Ti does not proceed excessively as long as it is under a condition of low oxygen partial pressure, an appropriate oxide film is formed in a portion in which the precious metal layer 3 is not formed on the substrate 2, even if there is such a portion.

That is , even in the case where it is used under an acidic atmosphere, the portion in which the precious metal layer 3 is formed maintains good conductivity, good corrosion resistance is provided by the precious metal layer 3, and the titanium oxide layer 5 (refer to Fig. 2(b)) will be formed in the portion where the precious metal layer 3 has not been formed because of pinholes and the like. Therefore, its corrosion resistance is not lowered.

The heat treatment of the substrate 2 in which the precious metal layer 3 is formed by a PVD method can be carried out by using a conventional heat treatment furnace such as electric furnaces and gas furnaces, the inside of which can be decompressed.

In contrast, since Au and Pt are not oxidized, they can be subjected to the heat treatment in an air atmosphere heat treatment. Therefore, when the precious metal is at least one member selected from Pt and Au, oxygen partial pressure can be the oxygen partial pressure under the atmospheric pressure or lower.

As mentioned above, when the precious metal layer forming step S2 is carried out at 300 to 800°C, the heat treatment step S3 can be carried out in a chamber with a low oxygen atmosphere simply by leaving it after the PVD method is completed, and therefore the manufacture of the fuel cell separator 1 is facilitated.

Herein, it is known that common products including Ti as the base material are prevented from becoming brittle by an amorphous passivation film formed on its surface, and Ti in the base material which bonds with hydrogen by such a passivation film. Accordingly, for example, under use conditions of about 25°C and about 0.1 MPa (1 atmospheric pressure), the above-mentioned passivation film prevents absorption of hydrogen, whereby bonding of Ti in the base material with hydrogen can be prevented and embrittlement is less likely to occur.

However, as the fuel cell separators, when it is exposed to hydrogen under use conditions of a high temperature and a high pressure (for example, 80 to 120°C, 0.2 to 0.3 MPa), it is difficult to sufficiently prevent the absorption of hydrogen since the above-mentioned passivation film is amorphous, and Ti in the base material may bond with absorbed hydrogen to cause embrittlement. Moreover, even when the precious metal layer 3 is formed on the substrate 2 by a PVD method (sputtering), there are portions where the substrate 2 is exposed out of the surface such as pinholes, and therefore hydrogen is absorbed from the pinholes, and may bond with Ti in the base material of the substrate 2 to cause embrittlement of the substrate 2.

In contrast, in the present invention, by carrying out the heat treatment at 300 to 800°C in the heat treatment step S3, the passivation film between the precious metal layer 3 and the substrate 2 is crystallized, and Ti of the substrate 2 exposed at pinholes is oxidized to form the titanium oxide layer 5 including at least one of rutile type crystals and brookite type crystals (refer to Fig. 2(b)). Since such a titanium oxide layer 5, has an effect to prevent the absorption of hydrogen (simply referred to as "hydrogen absorption prevention effect".) higher than an amorphous passivation film, and even in the case where it is exposed to hydrogen at a high temperature and under a high pressure with mentioned above, Ti does not bond with hydrogen, and embrittlement of the substrate 2 is unlikely to occur. It is also possible to obtain the above-mentioned hydrogen absorption prevention effect by a heat treatment under a high oxygen partial pressure such as an atmospheric pressure condition, but among the above-mentioned precious metals, Pd, Ru, Rh, Os and Ir form an oxide film when the oxygen partial pressure is high. Therefore, in order to provide both the above-mentioned hydrogen absorption prevention effect and conductivity, it is preferable that the oxygen partial pressure in the heat treatment step S3 of the present invention is 1.33 Pa (1×10⁻² Torr) or lower. In case of the precious metals which are not oxidized such as Au and Pt, both the hydrogen absorption prevention effect and conductivity can be provided even when the heat treatment step S3 is carried out under an atmospheric pressure condition.

As mentioned above, even when there is a passivation film between the precious metal element and the substrate, conductivity, adhesion, corrosion resistance and hydrogen absorption prevention effect can be provided at the same time by carrying out an appropriate heat treatment and turning the passivation film into a titanium oxide layer (including crystals). Therefore, as long as there is conductivity between the substrate 2 and the precious metal element and there is a layer having high corrosion resistance and ability to prevent hydrogen absorption, a similar effect can be obtained. Examples of such a layer include an oxide containing at least one element selected from Zr, Hf, Nb, Ta and Ti; nitride; carbide; oxynitride; oxycarbide; carbonitride; oxycarbonitride; a mixture of two or more members selected from oxide, nitride, and carbide; a mixture of these compounds and a metal containing at least one element selected from Zr, Hf, Nb, Ta and Ti; and laminates of these compounds and mixtures. That is, a similar effect can be obtained by forming a film from these compounds, mixtures and laminates by a PVD method such as sputtering, the vacuum vapor deposition method and ion plating and then forming the precious metal layer successively by a PVD method, followed by the heat treatment.

A similar effect can be also obtained by forming a Ti oxide film on the surface of Ti or a Ti alloy by the method of cleaning the surface of the substrate with acid to form the passivation film, the method of forming an anodized oxide film by anodizing, or by the method of conducting a heat treatment in air or in an atmosphere where oxygen is present, and then forming the precious metal layer successively by a PVD method, followed by the heat treatment.

One embodiment of the method for manufacturing a fuel cell separator according to the present invention has been described above, but the embodiment as will be described below can also be suitably carried out.

For example, the method for manufacturing a fuel cell separator may include a precious metal layer forming step in which the precious metal layer 3 including at least one precious metal selected from Ru, Rh, Pd, Os, Ir, Pt and Au and having a thickness of 2 nm or more is formed on the surface of the substrate 2 made of Ti or a Ti alloy by a PVD method, a recess formation step in which a recess for forming a gas channel for circulating a gas is formed in at least a part of the surface of the substrate 2 on which the precious metal layer 3 is formed, for example, by press forming or other methods, and a heat treatment step in which the substrate 2 on which the recess is formed is subjected to a heat treatment at the above-mentioned predetermined heat treatment temperature and under the predetermined oxygen partial pressure.

Furthermore, for example, the method for manufacturing a fuel cell separator may also include a precious metal layer forming step in which the precious metal layer 3 including at least one precious metal selected from Ru, Rh, Pd, Os, Ir, Pt and Au and having a thickness of 2 nm or more is formed on the surface of the substrate 2 made of Ti or a Ti alloy by a PVD method, a heat treatment step in which the substrate 2 on which the precious metal layer 3 is formed is subjected to a heat treatment at the above-mentioned predetermined heat treatment temperature and under the predetermined oxygen partial pressure, and a recess formation step in which a recess for forming a gas channel for circulating a gas is formed in at least a part of the surface of the substrate 2 which has been subjected to the heat treatment, for example, by press forming or other methods.

The fuel cell separator 1 according to the present invention produced by the above-mentioned method for manufacturing a fuel cell separator of the present invention will be now described in detail with reference to Fig. 2.

As shown in Fig. 2(a), the fuel cell separator 1, which is not encompassed within the scope of the present invention, is so constructed that the precious metal layer 3 including at least one precious metal selected from Ru, Rh, Pd, Os, Ir, Pt and Au is formed on the surface of the substrate 2 made of Ti or a Ti alloy on which a recess for forming the gas channel 11 (refer to Fig. 4) for circulating a gas is formed in at least a part of the surface. In the fuel cell separator 1, a recess need not be formed on the surface of the substrate 2 if the gas can be supplied to the solid polymer membrane 13 disposed between two fuel cell separators 1, 1 in the fuel cell 20 via the gas diffusion layers 12, 12 (refer to Fig. 5).

More specifically, the fuel cell separator 1 is so constructed that the precious metal layer 3 including at least one precious metal selected from Ru, Rh, Pd, Os, Ir, Pt and Au and having a thickness of 2 nm or more is formed on the surface of the substrate 2 by a PVD method, the precious metal layer 3 is subjected to a heat treatment at a predetermined heat treatment temperature and under a predetermined oxygen partial pressure to form the precious metal layer 3, and the diffusion layer 4 in which the element of the precious metal layer 3 and Ti of the substrate 2 are diffused into each other is formed between the precious metal layer 3 and the substrate 2.

The purposes of rendering the thickness of the precious metal layer 3 to fall within the above mentioned range, using the PVD method, and specifying the heat treatment temperature and oxygen partial pressure of the heat treatment had already been described in detail, and therefore their explanations are omitted.

When the thickness of the precious metal layer 3 is less than 1.5 nm, the barrier effect of the precious metal layer 3 becomes insufficient, and a passivation film is formed in the precious metal layer 3 and a portion directly under the diffusion layer 4 of the substrate 2 so that contact resistance may be increased.

There is no upper limit in the thickness of the precious metal layer 3, but the thickness is preferably 500 nm or less from the perspective of cost.

The diffusion layer 4 prevents an increase in electric resistance (contact resistance) between the substrate 2 and the precious metal layer 3.

When the fuel cell separator 1 according to the present invention includes the titanium oxide layer 5, for example, as shown in Fig. 2 (b), the titanium oxide layer 5 is formed between the precious metal layer 3 including at least one precious metal selected from Ru, Rh, Pd, Os, Ir, Pt and Au and the substrate 2 (that is, base material). When a pinhole P and other problems are formed in the precious metal layer 3 and there is a portion where the substrate 2 is exposed out of the surface, the titanium oxide layer 5 can be possibly formed directly under the pinhole P. In the present invention, this titanium oxide layer 5 is formed between the precious metal layer 3 and the substrate 2, and in the portion where the substrate 2 is exposed out of the surface (pinhole P).

Such a titanium oxide layer 5 can have both the hydrogen absorption prevention effect and conductivity when its thickness is about 0.5 to 10 nm. Since such a titanium oxide layer 5 is covered by the precious metal layer 3, or is formed under low oxygen partial pressure, it can contain at least one of rutile type crystals and brookite type crystals in an amount higher than in a usual passivation film.

The above-mentioned fuel cell according to the present invention will be now described with reference to drawings as appropriate.

As shown in Fig. 5, the fuel cell according to the present invention 20 is produced by using the above-mentioned fuel cell separator 1 according to the present invention, and can be produced in the following manner:

For example, a predetermined number of the substrate 2 made of Ti or a Ti alloy are prepared. These predetermined number of the substrate 2 is formed to have a predetermined dimension of 95.2 mm in longitudinal width×95.2 mm in lateral width×19 mm in thickness. A recess having, for example, a groove width of 0.6 mm, and a groove depth of 0.5 mm is formed in a central portion on the surface of the substrate 2 by machining, etching or by other means, thereby forming the gas channel 11 having the shape as shown in Fig. 4.

The substrate 2 on which the recess is formed is subjected to ultrasound wave cleaning with an organic solvent such as acetone, and then the substrate 2 is set in a chamber of a device for carrying out a PVD method, for example, a sputtering device. A vacuum is applied to the chamber, and argon gas is introduced therein. A voltage is applied to a target precious metal (for example, Au) to excite the argon gas and produce plasma, thereby forming the Au precious metal layer 3 on the substrate 2. The substrate 2 on which the precious metal layer 3 is thus formed is placed in a heat treatment furnace, and a vacuum is applied until a predetermined degree of vacuum is attained. A heat treatment in which the substrate is heated at 500°C for 5 minutes is carried out, thereby producing a predetermined number of the fuel cell separators 1.

By preparing a number of the substrates 2 in advance and subjecting these substrates to the formation of the precious metal layer 3 and heat treatment together, productivity can be improved. Moreover, according to the present invention, it is unnecessary to physically remove the passivation film with argon ion beam prior to forming the precious metal layer 3 as in a conventional method, and therefore productivity is improved than in a conventional case. In particular, in case of Au and Pt, there is no need to apply a vacuum, and the heat treatment can be carried out under atmospheric pressure and at the oxygen partial pressure, further improving the productivity.

Next, as shown in Fig. 5, a predetermined number of the fuel cell separators 1 produced, for example, using two of them, are disposed with their faces on which the gas channel 11 is formed facing each other, the gas diffusion layer 12 such as a carbon cloth C for uniformly diffusing a gas over the film is disposed on each face on which the gas channel 11 is formed, and the single cell 10 is produced by placing the solid polymer membrane 13 having a platinum catalyst applied on its surface between one gas diffusion layer 12 and the other gas diffusion layer 12. A plurality of the single cells 10 prepared similarly are stacked on one another to form a cell stack (not illustrated), other parts are attached to this cell stack which are necessary for a fuel cell, and connections and other processes are carried out, whereby the fuel cell (solid polymer fuel cell) 20 according to the present invention having good corrosion resistance and conductivity can be produced. Moreover, as mentioned above, in the fuel cell 20, if the gas can be supplied to the solid polymer membrane 13 from the fuel cell separator 1 via the gas diffusion layer 12, it is unnecessary to form a recess for forming the gas channel 11 on the surface of the substrate 2 (fuel cell separator 1).

The solid polymer membrane 13 used in the fuel cell 20 can be any membrane without any restriction as long as it functions to transfer protons produced at the cathode to the anode. For example, a fluorine-based polymer membrane having a sulfone group can be also used suitably.

The thus produced the fuel cell 20 introduces a fuel gas (for example, hydrogen gas having a purity of 99.999%) into the fuel cell separator 1 disposed as the anode via the gas channel 11, and introduces air into the fuel cell separator 1 disposed as the cathode via the gas channel 11. At this time, it is preferable that the dew-point temperature of the fuel cell 20 is adjusted to 80°C by heating and retaining the entire cell at about 80°C and passing the above-mentioned hydrogen gas and air through heated water. Moreover, it is desirable that the fuel gas (hydrogen gas) and air is introduced, for example, at a pressure of 2026 hPa (2 atmospheres).

In the fuel cell 20, by introducing the hydrogen gas into the anode in such a manner, the hydrogen gas is uniformly supplied over the solid polymer membrane 13 by the gas diffusion layer 12, and the reaction of the following formula (1) occurs in the solid polymer membrane 13.

H₂→2H⁺+2e⁻ (1)

Meanwhile, in the fuel cell 20, by introducing air into the cathode, air is uniformly supplied over the solid polymer membrane 13 by the gas diffusion layer 12, and the reaction of the following formula (2) occurs in the solid polymer membrane 13.

4H⁺+O₂+4e⁻→4e⁻→H₂O (2)

As mentioned above, the reactions of the formulae (1), (2) which occur in the solid polymer membrane 13 theoretically produce a voltage of about 1.2V.

Herein, as mentioned above, the fuel cell 20 according to the present invention can have good corrosion resistance and conductivity compared to a fuel cell which uses a known separator made of a metal since it uses the fuel cell separator 1 according to the present invention in which at least the precious metal layer 3 is formed.

### [Examples]

The method for manufacturing a fuel cell separator, fuel cell separator and fuel cell of the present invention will be now described specifically by comparing Examples which meet the requirements of the present invention and Comparative Examples which do not meet the requirements of the present invention.

### <Reference-Example A>

A Ti substrate (width: 2 cmx5 cm, thickness: 1 mm) made of a type of pure Ti defined in JIS H 4600 was subjected to ultrasound wave cleaning with acetone, and was then attached to a substrate table in the chamber of a magnetron sputtering apparatus which is an apparatus for conducting a PVD method. Pd was attached to the electrode in the chamber as a precious metal target, and then the chamber was evacuated to a vacuum of 0.00133 Pa (1×10⁻⁵ Torr) or lower.

Argon gas was introduced into the chamber, and the pressure was adjusted to 0.266 Pa (2×10⁻³ Torr). Thereafter, RF (high-frequency wave) was applied to the electrode to which Pd, the precious metal target, was attached, to excite the argon gas and produce argon plasma to perform sputtering of Pd, whereby a precious metal layer (hereinafter referred to as "precious metal layer (Pd)".) of Pd was formed on the surface of the substrate. Furthermore, the titanium substrate was reversed and a precious metal layer (Pd) having a thickness of 2 nm was formed on the other surface of the substrate by the same method.

In a manner similar to that mentioned above, substrates in which the thickness of the precious metal layer (Pd) of Pd was 1 nm, 3 nm, 5 nm, 10 nm and 50 nm, respectively, were prepared.

Next, these substrates on which the precious metal layer was formed were placed in a heat treatment furnace, and the furnace was evacuated until a vacuum of 0.133 Pa (1×10⁻³ Torr) was attained. After a heat treatment in which the substrates were heated at 500°C for 15 minutes was carried out, the inside of the furnace was cooled. When the temperature of the furnace reached 100°C, test plates on which the precious metal layer (Pd) was formed (equivalent to fuel cell separator) were drawn out.

Test plates were referred to as test plates 1 to 6 in the order of thickness of the precious metal layer (Pd) formed, from the thinnest to thickest (in the order of thickness: 1, 2, 3, 5, 10, 50 nm).
(1) These test plates 1 to 6 were measured for their contact resistance with a load of 98 N (10 kgf) before and after the heat treatment by using a contact resistance measurement apparatus 30 shown in Fig. 3. That is, each of test plates 1 to 6 was placed between carbon cloths C,C from its both sides, and further the outside of the cloths were pressurized at 98 N by copper electrodes 31,31 having a contact area of 1 cm². An electric current of 7.4 mA was applied using a direct current power supply 32, and the voltage applied between the carbon cloths C,C was determined by a voltmeter 33, calculating their contact resistances.
(2) Furthermore, each of test plates 1 to 6 was immersed in a sulfuric acid aqueous solution (pH2) at 80°C for 1000 hours, and then the contact resistance was determined again in a manner similar to that described above again. The contact resistance of (1) after the heat treatment and of (2) was rated acceptable when the measurement value was 12 mΩ·cm² or lower.
(3) Moreover, the adhesion test of the precious metal layer (Pd) before and after the heat treatment was evaluated by a grid pattern tape peeling test. The grid pattern tape peeling test was conducted according to the procedure described in the plating adhesion test method defined in JIS H8504.

The results of (1) the contact resistance before and after the heat treatment, (2) the contact resistance after being immersed in a sulfuric acid aqueous solution (pH2) at 80°C for 1000 hours, and (3) the grid pattern tape peeling test are shown in Table 1.

**[Table 1]**

| Test plate | Thickness of Pd film (nm) | Contact resistance (mΩ•cm²) | | | Grid pattern tape peeling test | | Remarks |
|---|---|---|---|---|---|---|---|
| | | Before heat treatment | After heat treatment | After being immersed in sulfuric acid for 1000 hours | Before heat treatment | After heat treatment | |
| 1 | 1 | 19.2 | 10.1 | 21.5 | Peeling found | No peeling found | Comparative example |
| 2 | 2 | 12.0 | 5.0 | 6.1 | Peeling found | No peeling found | Reference-Example |
| 3 | 3 | 9.5 | 4.0 | 4.3 | Peeling found | No peeling found | Reference-Example |
| 4 | 5 | 7.0 | 3.4 | 3.4 | Peeling found | No peeling found | Reference-Example |
| 5 | 10 | 6.8 | 3.3 | 3.3 | Peeling found | No peeling found | Reference-Example |
| 6 | 50 | 5.9 | 3.2 | 3.2 | Peeling found | No peeling found | Reference-Example |

It can be seen from the results shown in Table 1 that the contact resistance of all test plates 1 to 6 was lowered by undergoing the heat treatment.

In particular, Test plates 2 to 6 having the thickness of the precious metal layer (Pd) of 2 nm or more exhibit very low values of contact resistance of 5 mΩ·cm² or lower after the heat treatment, exhibiting excellent conductivity. Moreover, the results show that the contact resistance was not greatly increased even after being immersed in a sulfuric acid aqueous solution (pH2) at 80°C for 1000 hours, which indicates that they have high corrosion resistance. Moreover, the results of the grid pattern tape peeling test after the heat treatment show that there were no peeling after the heat treatment, which indicates that all of them have high adhesion between the precious metal layer and the substrate (these are all Reference-Examples).

Meanwhile, test plate 1 having the thickness of the precious metal layer (Pd) of 1 nm showed no peeling after the heat treatment as the result of the grid pattern tape peeling test after the heat treatment and had high adhesion between the precious metal layer and the substrate, but showed a small decrease in the contact resistance by the heat treatment, which indicates poor conductivity. It also showed a great increase in the contact resistance after being immersed in a sulfuric acid aqueous solution (pH2) at 80°C for 1000 hours, indicating poor corrosion resistance (Comparative Example).

Observation of a cross section of test plate 4 (thickness of the precious metal layer (Pd): 5 nm) by TEM (transmission electron microscope)) revealed that there was no oxide (that is, passivation film) between the precious metal layer and the substrate, but there was a diffusion layer in which Ti and Pd were diffused into each other having a thickness of about 5 nm.

### <Example B>

Precious metal layers made of a precious metal (Au and Pt) were formed on two substrates made of a Ti-6Al-4V alloy in a thickness of 10 nm, 30 nm, respectively, by a PVD method (sputtering) in a manner similar to < Reference-Example A>.

Thereafter, the Ti-6Al-4V alloy plates on which the precious metal layer was formed were placed in a heat treatment furnace heated to 500°C under atmospheric pressure to conduct a heat treatment for one minute, whereby substrates (test plates 7, 9) on which the precious metal layer (Au) was formed and substrates (test plates 8, 10) on which the precious metal layer (Pt) was formed were produced.
(1) The contact resistance of these test plates 7 to 10 before and after the heat treatment was determined. Measurement of the contact resistance was conducted according to the procedure of <Example A>, except that Au foils (not illustrated) were used instead of that the carbon cloths C, C to conduct measurement, and the voltage applied between the Au foils were determined to calculate the contact resistance.

Moreover, (2) measurement of the contact resistance after being immersed in a sulfuric acid aqueous solution (pH2) at 80°C for 1000 hours was conducted, and (3) the adhesion tests of the precious metal layer (Au) and precious metal layer (Pt) before and after the heat treatment were evaluated by the grid pattern tape peeling test. The contact resistance of (1) after the heat treatment and (2) was rated acceptable when the measurement value was 0.5 mΩ·cm² or lower

Moreover, to determine the structure of the interface between of the precious metal thin film and the Ti-6Al-4V substrate, a cross section of test plate 7 was observed by using a transmission electronic microscope (TEM). The observational conditions of the TEM were as follows: thickness of sample: about 100 nm, acceleration voltage: 200kV, magnification: 1,500,000 times.
(1) The results of the contact resistance before and after the heat treatment, (2) the contact resistance after being immersed in a sulfuric acid aqueous solution (pH2) at 80°C for 1000 hours, and (3) the grid pattern tape peeling test are shown in Table 2.

**[Table 2]**

| Test plate | Type of film | Thickness of film (nm) | Contact resistance (mΩ•cm²) | | | Grid pattern tape peeling test | | Remarks |
|---|---|---|---|---|---|---|---|---|
| | | | Before heat treatment | After heat treatment | After being immersed in sulfuric acid for 1000 hours | Before heat treatment | After heat treatment | |
| 7 | Au | 10 | 3.6 | 0.1 | 0.2 | Peeling found | No peeling found | Example |
| 8 | Pt | 10 | 3.8 | 0.2 | 0.2 | Peeling found | No peeling found | Example |
| 9 | Au | 30 | 3.2 | 0.1 | 0.1 | Peeling found | No peeling found | Example |
| 10 | Pt | 30 | 3.3 | 0.1 | 0.1 | Peeling found | No peeling found | Example |

It can be seen from the results shown in Table 2 that the contact resistance of test plates 7 to 10 were lowered by the heat treatment under the oxygen partial pressure condition by the atmospheric pressure, and their adhesion were also improved. Furthermore, there was no increase in the contact resistance found even after being immersed in a sulfuric acid aqueous solution (pH2) at 80°C for 1000 hours, which indicates that they have excellent corrosion resistance. Moreover, it was confirmed from the results of the observation using the TEM that there was a titanium oxide layer having a thickness of about 5 nm between the precious metal layer (Au) and the substrate. Furthermore, the crystal structure of the titanium oxide layer by the electron nanodiffraction was determined to find that rutile type crystals were contained.

### <Example C>

Various kinds of precious metals shown in Table 3 were deposited on substrates made of Ti-5Ta by the vacuum vapor deposition method b to form precious metal layers, each having a thickness of 5 nm.

A precious metal was placed in a crucible (carbon crucible) in the chamber of the vacuum deposition apparatus in which the vacuum vapor deposition method is carried out. A substrate made of Ti-5Ta was set thereabove. The chamber was evacuated to a vacuum of 0.000133 Pa (1×10⁻⁶ Torr), and then the precious metal in the crucible was irradiated with an electron beam under the following conditions: acceleration voltage: 5kV, emission current: 50 mA, whereby the precious metal was dissolved and evaporated to form a precious metal layer on the substrate made of Ti-5Ta. The thickness of the precious metal layer was measured by a change in the frequency of a quartz thickness monitor, and formation of the precious metal layer was terminated at the point where its thickness became 5 nm. Thereafter, a precious metal layer was also formed on its back side in a similar manner, whereby a precious metal layer was formed on both sides.

Thereafter, the substrate made of Ti-5Ta on which precious metal layers were formed was placed in a heat treatment furnace. The furnace was evacuated to a vacuum of 0.00133 Pa (1×10⁻⁵ Torr), and was heated to the predetermined temperature shown in Table 3. Thereafter, oxygen was introduced into the furnace to conduct a heat treatment while evacuating the furnace so that the predetermined oxygen partial pressures shown in Table 3 were attained, thereby producing test plates 11 to 20.

By using these test plates 11 to 20, (1) the contact resistance before and after the heat treatment was determined. The measurement of contact resistance was conducted according to <Reference-Example A>. In <Example C>, carbon cloths were used in the measurement
(2) Furthermore, each of test plates 11 to 20 was immersed in a sulfuric acid aqueous solution (pH2) at 80°C for 1000 hours, and then its contact resistance was determined again in a manner similar. The contact resistance of (1) after the heat treatment and (2) was rated acceptable when the measurement value was 12mΩ·cm² or lower.

The results of (1) the contact resistance before and after the heat treatment, and (2) the contact resistance after being immersed in a sulfuric acid aqueous solution (pH2) at 80°C for 1000 hours are shown in Table 3.

**[Table 3]**

| Test plate | Type of film | Heat treatment conditions | | | Contact resistance (mΩ•cm²) | | | Remarks |
|---|---|---|---|---|---|---|---|---|
| | | Oxygen partial pressure (Pa) | Heat treatment temperature (°C) | Heat treatment time (min.) | Before heat treatment | After heat treatment | After sulfuric acid immersion | |
| 11 | Ru | 0.0133 | 300 | 60 | 7.9 | 3.0 | 3.2 | Example |
| 12 | Pd | 1.33 | 350 | 30 | 7.1 | 3.9 | 4.1 | Example |
| 13 | Ru | 0.133 | 400 | 15 | 7.8 | 3.5 | 3.5 | Example |
| 14 | Rh | 0.0665 | 800 | 1 | 8.0 | 3.2 | 3.3 | Example |
| 15 | Os | 0.0665 | 600 | 3 | 8.3 | 3.1 | 3.2 | Example |
| 16 | Ir | 0.133 | 700 | 1 | 7.1 | 3.6 | 3.6 | Example |
| 17 | Pd | 0.665 | 500 | 70 | 7.3 | 12.2 | 17.5 | Comparative example |
| 18 | Pd | 13.3 | 500 | 5 | 7.5 | 8.5 | 18.9 | Comparative example |
| 19 | Au | 0.133 | 850 | 1 | 6.9 | 15.5 | 19.9 | Comparative example |
| 20 | Ru | 0.0133 | 200 | 60 | 7.3 | 6.9 | 7.0 | Comparative example |

It can be seen from the results shown in Table 3 that among test plates 11 to 17 which were subjected to a heat treatment under the oxygen partial pressure of 1.33 Pa (1×10⁻² Torr) or lower and at a temperature ranging from 300°C to 800°C, test plates 11 to 16 were given low contact resistance.

In contrast, the diffusion layers of Pd and Ti have grown excessively in test plate 17 since the treatment time was too long, and Ti was diffused into the outermost surface to form titanium oxide on the outermost surface. Therefore, its contact resistance was not lowered.

In test plate 18, the contact resistance was not lowered since the oxygen partial pressure was high and Pd was thus oxidized.

In test plate 19, the diffusion layers of Au and Ti have grown excessively since the heat treatment temperature was too high, and Ti was diffused into the outermost surface to form titanium oxide on the outermost surface. Therefore, its contact resistance was not lowered.

In test plate 20, crystallization of the passivation film was not achieved since the heat treatment temperature was low. In addition, since its thickness remained substantially the same, substantially no decrease in the contact resistance was found. Although its contact resistance after being immersed in a sulfuric acid was low, a circular peeling in a diameter of about 1 mm was found.

### <Example D>

First, eight sheets of a type of Ti substrates defined in JIS H 4600 made of pure Ti (width: 2 cm×5 cm, thickness: 0.2 mm) were prepared. The surface of these Ti substrates were treated by a PVD method (sputtering) under the conditions same as those described in <Example A>, whereby a precious metal layer of Au and Pt having a thickness of 10 nm was formed on each Ti substrate (test plates 21 to 28).

Thereafter, test plates 22, 26 on which the precious metal layer was formed were subjected to a heat treatment under an atmospheric pressure condition (oxygen partial pressure: 2.13×10⁴ Pa) at 500°C for 1 minute.

Moreover, test plates 23, 24, 27, 28 on which the precious metal layer was formed was placed in a vacuum heat treatment furnace. The furnace was evacuated until the pressure in the furnace was 0.00133 Pa (1×10⁻⁵ Torr), and was heated to 500°C. Dry air was introduced to adjust the oxygen partial pressure in the furnace to, as shown in Table 4 below, 0.133 Pa (1×10⁻³ Torr) or 0.00133 Pa (1×10⁻⁵ Torr), and a heat treatment was conducted at 500°C for 5 minutes under such oxygen partial pressures.

In order to compare with test plates 22 to 24, 26 to 28, two Ti substrates of test plates 21, 25 were not subjected to the heat treatment under heat treatment conditions shown in Table 4 after the precious metal layers of Au and Pt having a thickness of 10 nm were formed.

The contact resistance of the above-mentioned test plates 21 to 28 were determined under the conditions same as described in <Example B> and calculated.

Moreover, these test plates 21 to 28 were placed in a gas phase portion of an airtight container containing water and hydrogen at 0.3 MPa (3 atm). the container was heated at 120°C to expose the test plates to an atmosphere of pure hydrogen (purity 99.99%) humidified to a humidity of about 100% (hereinafter simply referred to as "in a humidified pure hydrogen atmosphere".) for 500 hours. The samples placed in a graphite crucible were heated and dissolved together with tin by the graphite resistor heating method, whereby hydrogen was extracted together with other gases. The extracted gas was passed through a separation column to separate hydrogen from other gases. The separated hydrogen was transferred to a thermal conductivity detector to determine a change in thermal conduction caused by hydrogen (inert gas fusion-gas chromatography), thereby determining the hydrogen concentrations in test plates 21 to 28 (ppm).

The contact resistance and the hydrogen concentrations in test plates 21 to 28 (shown as "hydrogen concentrations in test plates" in Table 4.) are shown in Table 4 below together with the above-mentioned heat treatment conditions and the like. The contact resistance was rated acceptable when the measurement value was 0.5mΩ·cm² or lower, and the hydrogen concentrations in the Ti substrates were rated acceptable when the measurement value was 70 ppm or lower.

**[Table 4]**

| Test plate | Precious metal | Heat treatment conditions | | | Contact resistance (mΩ•cm2) | Hydrogen concentration in test plates (ppm) | Remarks |
|---|---|---|---|---|---|---|---|
| | | Oxygen partial pressure (Pa) | Heat treatment temperature (°C) | Heat treatment time (min.) | | | |
| 21 | Au | - | - | - | 3.6 | 98 | Comparative example |
| 22 | Au | 2.13 × 10⁴ | 500 | 1 | 0.2 | 30 | Example |
| 23 | Au | 0.133 | 500 | 5 | 0.1 | 29 | Example |
| 24 | Au | 0.00133 | 500 | 5 | 0.1 | 29 | Example |
| 25 | Pt | - | - | - | 3.8 | 100 | Comparative example |
| 26 | Pt | 2.13 × 10⁴ | 500 | 1 | 0.2 | 32 | Example |
| 27 | Pt | 0.133 | 500 | 5 | 0.1 | 30 | Example |
| 28 | Pt | 0.00133 | 500 | 5 | 0.1 | 28 | Example |

Herein, the concentration of hydrogen contained pure Ti material which is a type of materials defined in JIS H 4600 is normally about 20 to 40 ppm.

As shown in Table 4, test plates 21, 25 which were not subjected to the heat treatment under the heat treatment conditions shown in Table 4 have rather high values of contact resistance, and have also high values of the hydrogen concentrations. That is, good results could not be obtained. Since the values of the hydrogen concentrations in the test plates were high, it was found that hydrogen was absorbed by the base material in the Ti substrate by being exposed to the humidified pure hydrogen atmosphere for 500 hours.

As shown in Table 4, test plates 22 to 24, 26 to 28 which have been subjected to the heat treatment under the heat treatment conditions shown in Table 4 have low values of contact resistance, and also have low values of the hydrogen concentrations. That is, good results could be obtained.

It was confirmed from the results of <Example D> that the contact resistance could be lowered by the heat treatment in test plates 22 to 24, 26 to 28, and that they did not absorb hydrogen even in the case where they were exposed to the humidified pure hydrogen atmosphere for 500 hours.

### <Example E>

A Ti substrate (width: 2 cm×5 cm, thickness: 1 mm) made of a type of pure Ti defined in JIS H 4600 was subjected to ultrasound wave cleaning with acetone, and was then attached onto a substrate table in the chamber of a magnetron sputtering apparatus which is an apparatus for conducting a PVD method. Au was attached to the electrode in the chamber as the precious metal target, and then the chamber was evacuated to a vacuum of 0.00133 Pa (1×10⁻⁵ Torr) or lower.

Argon gas was introduced into the chamber until the pressure was adjusted to 0.266 Pa (2×10⁻³ Torr). Thereafter, a DC (direct current) voltage was applied to the electrode to which Au, which is the precious metal target, is attached to excite the argon gas. Au was sputtered by the produced argon plasma, forming a precious metal layer of Au (hereinafter "precious metal layer (Au)") having a thickness of 20 nm was formed on the surface of the substrate. Furthermore, the titanium substrate was reversed and a precious metal layer (Au) having a thickness of 20 nm was formed also on the other surface of the substrate by the same method.

Thereafter, the substrate made of Ti on which the precious metal layers (Au) were formed was placed in a heat treatment furnace. The furnace was evacuated until a vacuum of 0.00133 Pa (1×10⁻⁵ Torr) was attained, and was heated to the predetermined temperature shown in Table 5. Oxygen was introduced into the furnace while evacuating the furnace so that the oxygen partial pressure of 0.00665 Pa (5×10⁻⁵ Torr) was attained, and a heat treatment was carried out, thereby producing test plates 29 to 41.

By using these test plates 29 to 41, (1) the contact resistance before and after the heat treatment was determined. The measurement of contact resistance was conducted according to <Reference-Example A>. In <Example E>, Au foils were used instead of the carbon cloths in the measurement.
(2) Furthermore, each of test plates 29 to 41 was immersed in a sulfuric acid aqueous solution (pH2) at 80°C for 1000 hours, and then its contact resistance was determined again in a manner similar to that described above. The contact resistance of (1) after the heat treatment and (2) was rated acceptable when the measurement value was 0.5 mΩ·cm² or lower.

The results of (1) the contact resistance before and after the heat treatment, and (2) the contact resistance after being immersed in a sulfuric acid aqueous solution (pH2) at 80°C for 1000 hours are shown in Table 5.

**[Table 5]**

| Test plate | Heat treatment conditions | | Contact resistance (mΩ•cm²) | | | Remarks |
|---|---|---|---|---|---|---|
| | Heat treatment temperature (°C) | Heat treatment time (min.) | Before heat treatment | After heat treatment | After sulfuric acid immersion | |
| 29 | 300 | 5 | 3.3 | 0.4 | 0.5 | Example |
| 30 | 300 | 20 | 3.6 | 0.2 | 0.4 | Example |
| 31 | 400 | 1 | 3.2 | 0.1 | 0.1 | Example |
| 32 | 400 | 5 | 3.6 | 0.2 | 0.2 | Example |
| 33 | 500 | 5 | 3.7 | 0.2 | 0.2 | Example |
| 34 | 600 | 1 | 3.1 | 0.2 | 0.2 | Example |
| 35 | 660 | 1 | 3.3 | 0.2 | 0.2 | Example |
| 36 | 320 | 1 | 3.7 | 1.8 | 3.2 | Comparative example |
| 37 | 400 | 0.25 | 3.4 | 1.5 | 1.7 | Comparative example |
| 38 | 500 | 0.25 | 3.1 | 1.2 | 1.5 | Comparative example |
| 39 | 500 | 25 | 3.2 | 0.7 | 1.0 | Comparative example |
| 40 | 700 | 5 | 3.6 | 1.2 | 1.3 | Comparative example |
| 41 | 400 | 60 | 3.3 | 1.5 | 1.7 | Comparative example |

It can be seen from the results shown in Table 5 that test plates 29 to 35 are imparted low contact resistance because they have been subjected to the heat treatment in a range expressed by (420-T) / 40≤t≤EXP [(806.4-T)/109.2] and t≥0.5 (300≤T≤800), where the heat treatment time is t (minutes) and the heat treatment temperature is T (°C).

In contrast, test plates 36, 37 did not meet (420-T)/40≤t, and therefore the treatment time was too short. The test plate 38 did not meet t≥0.5, and therefore the treatment time was too short. Accordingly, in test plates 36 to 38, improvement in conductivity by crystallizing the passivation film which was present between Au and the substrate crystallization was insufficient, and therefore the contact resistance was not lowered.

In test plates 39 to 41, the treatment time was too long and therefore the diffusion layers of Au and Ti have grown excessively. Therefore, Ti was diffused into the outermost surface, resulting in the formation of titanium oxide on the outermost surface. The contact resistance was thus not lowered.

### <Example F>

Next in <Example F>, power generation test was carried out in the case where the separator prepared by using the Ti substrate of the above-mentioned test plate 7 was used.

First, two Ti substrates having a longitudinal width of 95.2 mm, lateral width of 95.2 mm and a thickness of 19 mm were prepared. A gas channel having a groove width of 0.6 mm and a groove depth of 0.5 mm was prepared in the central portions on their surfaces, respectively, in the shape shown in Fig. 4 by machining. Formation of Au films on the Ti substrates having the gas channel formed thereon and heat treatment were carried out by the procedure and under conditions similar to those of <Reference-Example A> to prepare separators.

Power generation test was carried out by integrating the two produced separators into solid polymer fuel cells (manufactured by Electrochem, fuel cell EFC-05-01SP) in the following manner.

First, as shown in Fig. 5, the produced two separators were disposed with their faces on which the gas channel is formed facing each other. A carbon cloth was disposed on each of the surfaces on which the gas channel is formed. A solid polymer membrane was placed between these carbon cloths to prepare a fuel cell for power generation test.

Hydrogen gas having a purity of 99.999% was used as a fuel gas introduced to the anode side of the fuel cell produced in the manner described above, and air was used as a gas introduced to the cathode side.

The entire fuel cell was heated to and retained at 80°C. The hydrogen gas and air were adjusted to have a dew-point temperature of 80°C by being passed through heated water, and were introduced into the above mentioned fuel cell at a pressure of 2026 hPa (2 atmospheres).

By using a cell performance measurement system (890CL manufactured by Scribner), a change in the voltage was measured by generating power for 100 hours with the current flowing to the separator being 300 mA/cm2.

As a result, the voltage early in the power generation of the separator of the Ti substrate of test plate 7 and the voltage after carrying out power generation for 100 hours were both 0.61 V, exhibiting no change in the voltage.

Moreover, as a comparison, a fuel cell was produced by disposing a graphite separator (FC-05MP manufactured by Electrochem) which has been conventionally used in place of the Ti substrate of test plate 7, and power generation test was carried out under the same conditions as above.

As a result, the voltage early in the power generation and the voltage after carrying out power generation for 100 hours were both 0.61 V, showing results exactly the same as the separator of the Ti substrate of test plate 7.

The above mentioned results reveals that a fuel cell separator produced by the method for manufacturing a fuel cell separator of the present invention exhibits performance similar to that of a graphite separator although it is a separator made of a metal.

The present application is based on Japanese patent application No.2006-268352 applied as of September 29, 2006, Japanese patent application No. 2007-024418 applied as of February 2, 2007, and Japanese patent application No. 2007-201240 applied as of August 1, 2007.

According to the method for manufacturing a fuel cell separator of the present invention, a fuel cell separator made of Ti or a Ti alloy having excellent corrosion resistance, good adhesion of a precious metal layer because of the passivation film which has been crystallized, low contact resistance, and further excellent productivity can be produced.

Moreover, the fuel cell separator according to the present invention has excellent corrosion resistance, good adhesion of the precious metal layer, low contact resistance, and further excellent productivity.

In addition, the fuel cell according to the present invention has excellent corrosion resistance, good adhesion of the precious metal layer, low contact resistance, and further excellent productivity.

## Claims

1. A fuel cell separator wherein
a precious metal layer comprising at least one precious metal selected from Ru, Rh, Pd, Os, Ir, Pt and Au and having a thickness of 2 nm or more is formed on the surface of a substrate made of Ti or a Ti alloy, and wherein
titanium oxide layer comprising at least one of rutile type crystals and brookite type crystals is formed between the precious metal layer and the substrate and in a portion where the substrate is exposed out of the surface.

2. The fuel cell separator according to claim 1, wherein the substrate has a recess for forming a gas channel for circulating a gas formed in at least a part of the surface thereof, and the precious metal layer is formed on the surface of the substrate on which the recess was formed.

3. A fuel cell comprising a fuel cell separator according to claim 1 or 2.

## Patentansprüche

1. Brennstoffzellenseparator, wobei
eine Edelmetallschicht, umfassend mindestens ein Edelmetall, ausgewählt aus Ru, Rh, Pd, Os, Ir, Pt und Au, und mit einer Dicke von 2 nm oder mehr auf der Oberfläche von einem Substrat, hergestellt aus Ti oder einer Ti-Legierung, gebildet ist, und wobei
eine Titanoxidschicht, umfassend mindestens eines aus Kristallen vom Rutil-Typ und Kristallen vom Brookit-Typ, zwischen der Edelmetallschicht und dem Substrat und in einem Bereich, wo das Substrat der Oberfläche freigelegt ist, gebildet ist.

2. Brennstoffzellenseparator nach Anspruch 1, wobei das Substrat eine Aussparung zum Bilden eines Gaskanals für das Zirkulieren eines Gases aufweist, gebildet zumindest in einem Teil von dessen Oberfläche, und die Edelmetallschicht auf der Oberfläche von dem Substrat gebildet ist, auf welcher die Aussparung gebildet wurde.

3. Brennstoffzelle, umfassend einen Brennstoffzellenseparator nach Anspruch 1 oder 2.

## Revendications

1. Séparateur de pile à combustible dans lequel,
une couche de métal précieux comprenant au moins un métal précieux sélectionné parmi Ru, Rh, Pd, Os, Ir, Pt et Au et ayant une épaisseur de 2 nm ou plus est formée sur la surface d'un substrat fait de Ti ou d'un alliage de Ti, et dans lequel,
la couche d'oxyde de titane comprenant au moins un parmi des cristaux de type rutile et des cristaux de type brookite est formée entre la couche de métal précieux et le substrat et dans une partie où le substrat est exposé en dehors de la surface.

2. Le séparateur de pile à combustible selon la revendication 1, dans lequel le susbstrat a un évidement pour former un canal de gaz pour faire circuler un gaz formé dans au moins une partie de la surface de celui-ci, et la couche de métal précieux est formée sur la surface du substrat sur laquelle l'évidement est formé.

3. Pile à combustible comprenant un séparateur de pile à combustible selon la revendication 1 ou 2.
